Europäisches Patentamt

European Patent Office

Office européen des brevets

(19)

(11) Publication number: **0 034 341**
**B1**

(12) **EUROPEAN PATENT SPECIFICATION**

(45) Date of publication of patent specification: **04.06.86**

(21) Application number: **81100998.4**

(22) Date of filing: **12.02.81**

(51) Int. Cl.⁴: **H 01 L 21/82,** H 01 L 21/285, H 01 L 21/60, H 01 L 27/02

(54) Method for manufacturing a semiconductor device.

(30) Priority: **18.02.80 JP 18690/80**

(43) Date of publication of application:
**26.08.81 Bulletin 81/34**

(45) Publication of the grant of the patent:
**04.06.86 Bulletin 86/23**

(84) Designated Contracting States:
**DE FR GB NL**

(56) References cited:
**INTERNATIONAL ELECTRON DEVICES
MEETING, Technical Digest, December 3-5,
1979, Washington, USA D.D. TANG et al.
"Sub-nanosecond selfaligned I2L/MTL circuits",
pages 201-204**

**IBM TECHNICAL DISCLOSURE BULLETIN vol.
22, no. 7, December 1979, New York, USA H.H.
BERGER et al. Double polysilicon MTL
structure", pages 2876-2788.**

(73) Proprietor: **Kabushiki Kaisha Toshiba
72, Horikawa-cho Saiwai-ku
Kawasaki-shi Kanagawa-ken 210 (JP)**

(72) Inventor: **Kanzaki, Koichi
2-10-1, Miyamaedaira
Takatsu-ku Kawasaki-shi (JP)**
Inventor: **Taguchi, Minoru
1-800-59, Nisshin-cho
Omiya-shi Saitama-ken (JP)**

(74) Representative: **Henkel, Feiler, Hänzel & Partner
Möhlstrasse 37
D-8000 München 80 (DE)**

(56) References cited:
**IBM TECHNICAL DISCLOSURE BULLETIN vol.
22, no. 8A, January 1980, New York, USA G.C.
FETH et al. "Polysilicon merged transistor logic
device", pages 3388-3390.**

**IEEE JOURNAL OF SOLID-STATE CIRCUITS,
vol. SC-12, no. 2, April 1977, New York, USA J.
MIDDELHOEK et al. "Polycrystalline silicon as a
diffusion source and interconnect layer in I2L
realizations", pages 135-138.**

Courier Press, Leamington Spa, England.

(56) References cited:
**IBM TECHNICAL DISCLOSURE BULLETIN, vol. 22, no. 7, December 1979, New York, USA G.C. FETH et al. "Layout image for merged transistor logic", pages 2948-2951.**

**IBM TECHNICAL DISCLOSURE BULLETIN vol. 22, no. 8A, January 1980, New York, USA R.D. ISAAC et al. "Method of fabricating a self aligned vertical pnp transistor", pages 3393-3396.**

## Description

The present invention relates to a method for manufacturing a semiconductor device and, more particularly, to a method for manufacturing an integrated injection logic semiconductor device.

The integrated injection logic ($I^2L$) gate, having many attractive features such as high speed operation, low power consumption, high packing density, and coexistence with linear transistors, has intensively been studied and developed for further improvement of the operation speed and the packing density. The $I^2L$ gate having excellent features is disclosed in IEDM Technical Digest, December 3 to 5, 1979, pp. 201 to 204. In the $I^2L$ gate, a vertical transistor, i.e., a switching transistor, is provided at both sides not with the low resistance rail regions but with oxide isolation directly contacting therewith. The extrinsic base regions between the collector regions are commonly connected by an overlaying aluminium layer. With such a structure of the $I^2L$ gate, there is no need for the low resistance rail regions. For this reason, an area of the base region of the switching transistor is extremly small and, therefore, the storage time of minority carriers becomes small. As a result, the packing density as well as the operation speed of the $I^2L$ is improved. In manufacturing the $I^2L$ gate, however, the base region of a lateral transistor, i.e. an injector transistor, is formed by a masked boron implantation and then the step for forming the collector regions of the switching regions is performed, that is to say, arsenic-doped polisilicon layers are formed and patterned. Therefore, in forming polysilicon layers after the formation of the base of the injector transistor, some margin must previously be provided in preparation for an inevitable error in the masking. Because of the use of the margin, the collector region of the switching transistor, i.e. base contact region most adjacent to the injector transistor formed right under the arsenic-doped polisilicon layer has a wide gap with respect to the base region of the injector transistor. The wider gap hinders further improvement of the packing density and operation speed of the $I^2L$ gate.

Accordingly, an object of the present invention is to provide a method for manufacturing a semiconductor device which enables the $I^2L$ elements to have higher packing density and operation speed.

According to the present invention, a mask is partially formed by an insulating film on a semiconductor island surrounded by a recessed oxid insulation. Impurity is doped into the semiconductor island through a window of the mask to form a base region of the switching transistor. In the same process step, impurity-doped polysilicon layers are formed on the base region and the insulating layer surface of the mask. With a mask of the polysilicon layers, impurity is doped into the semiconductor island and the base region to form the emitter and collector regions of the injector transistor, and an external base of the switching transistor. The collector regions of the switching transistor are formed by diffusing impurity contained in the impurity-doped polysilicon layers on the base region therein.

This invention can be more fully understood from the following detailed description when taken in conjunction with the accompanying drawings, in which:

Figs. 1A to 1F show semiconductor structures in the respective manufacturing steps of an $I^2L$ device according to an embodiment of a method for manufacturing a semiconductor device of the present invention;

Fig. 2 shows a plan view of the semiconductor structure shown in Fig. 1B;

Fig. 3 is a plan view of the semiconductor structure shown in Fig. 1F; and

Fig. 4 is a characteristic curve of the $I^2L$ device.

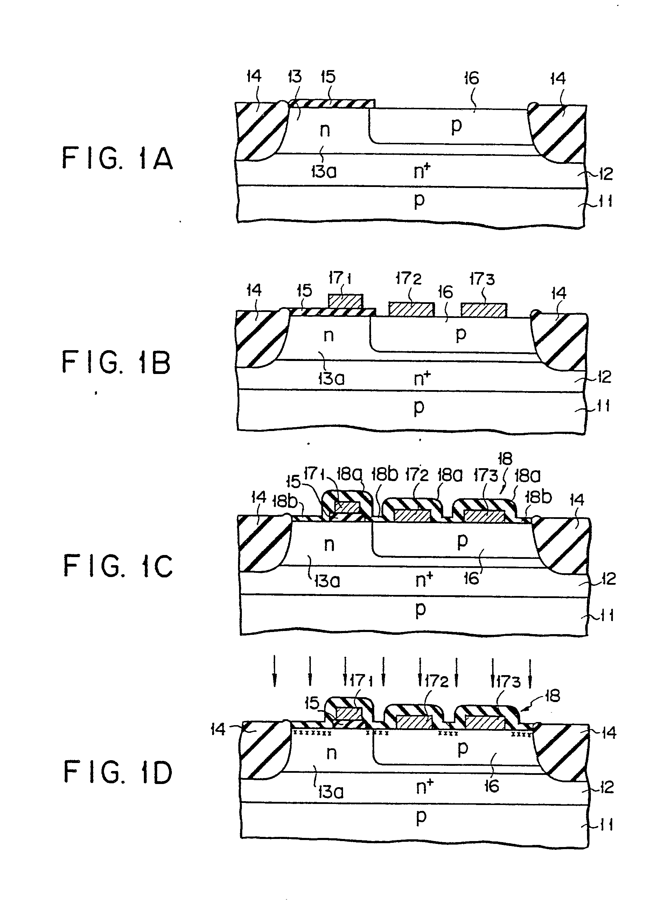

A method for manufacturing a semiconductor device according to the present invention will be described referring to Figs. 1A to 1F. In a step of Fig. 1A, an $n^+$ buried region 12 is formed on a p-type semiconductor substrate, i.e. a p-type silicon substrate 11. An n-type epitaxial layer 13 is further formed on the buried region 12. A field oxide layer 14 is formed onto the epitaxial layer 13 by a selective diffusion process to form at least one n-type island region 13a in the epitaxial layer 13. An oxide layer 15 is partially formed on the surface of the island region 13a. With a mask of the oxide layer 15, p-type impurity such as boron is doped into the island region 13a to form a p-type region 16 in the island region 13a. The p-type region 16, however, may be formed by the following process. That is, an oxide layer 15 is formed on the entire surface of the island region 13a. On the oxide layer 15 is partially formed a resist film. Using the resist film as a mask, p-type impurity such as boron is doped in the island region 13a to form the p-type region 16 in the island region 13a. Then, that part of the oxide layer 15 which is disposed on the p-type region 16 is etched away.

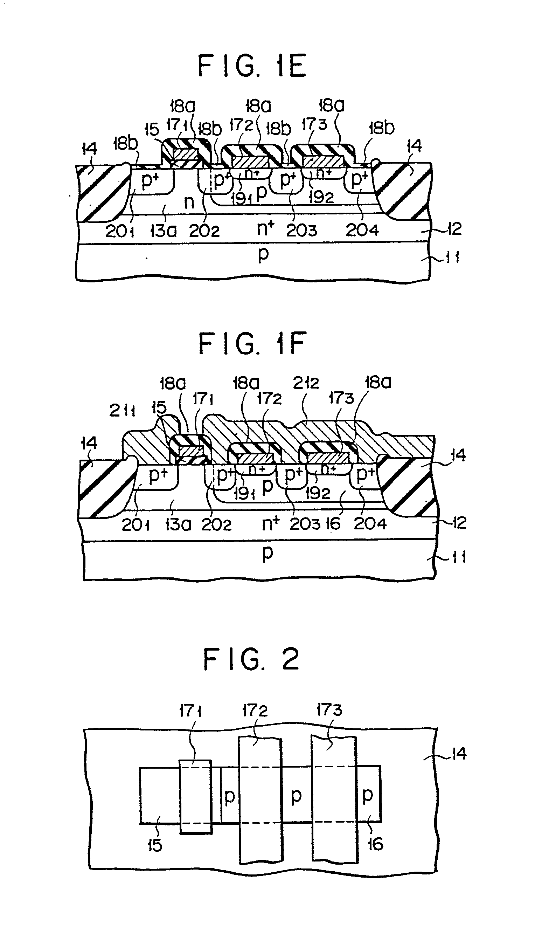

In a step of Fig. 1B, polysilicon layers $17_1$ to $17_3$ doped with arsenic, for example, are selectively formed on the surfaces of the oxide layer 15 and p-type region 16. The polysilicon layers $17_1$ to $17_3$ cross the oxide layer 15 and p-type region 16, extending to the field oxide layer 14, as well illustrated in Fig. 2.

In a step of Fig. 1C, the oxide layer 15 is etched away with a mask of the polysilicon layer $17_1$. Then, an oxide layer 18 having thick layer portions 18a of about 3,000 Å which enclose the polysilicon layers $17_1$ to $17_3$ and thin layer portions 18b of about 300 Å is formed on the chip surface by a wet oxidation at low temperature.

In Fig. 1D, boron ion, for example, is injected into the island region 13a and the p-type region 16, using the polysilicon layers $17_1$ to $17_3$ and the oxide layer 18 as a mask. In the same step, then the semiconductor chip is subjected to a thermal process. As a result of the heat treatment, arsenic contained in the polysilicon layers $17_2$ and $17_3$ is diffused into the p-type region 16, as shown in Fig. 1E to form $n^+$-type regions $19_1$ and $19_2$, while

at the same time injected boron is diffused into the island region 13a and the first region 16 to form $p^+$-type regions $20_1$ to $20_4$.

In a step of Fig. 1F, electrodes $21_1$ and $21_2$ are formed on the $p^+$-type regions $20_1$ to $20_4$. In forming the electrodes, contact holes are firstly formed on the $p^+$-type regions $20_1$ to $20_4$. As recalled, the layer portions 18a on the polysilicon layers $17_1$ to $17_3$ are thick while the layer portions 18b are thin. Therefore, merely by properly controlling an etching time and not by a mask process, the thin layer portions 18b are etched away to form the contact holes, while the polysilicon layers $17_1$ to $17_3$ are left unexposured. After the formation of the contact holes, aluminium is deposited and patterned over the surface of the semiconductor chip.

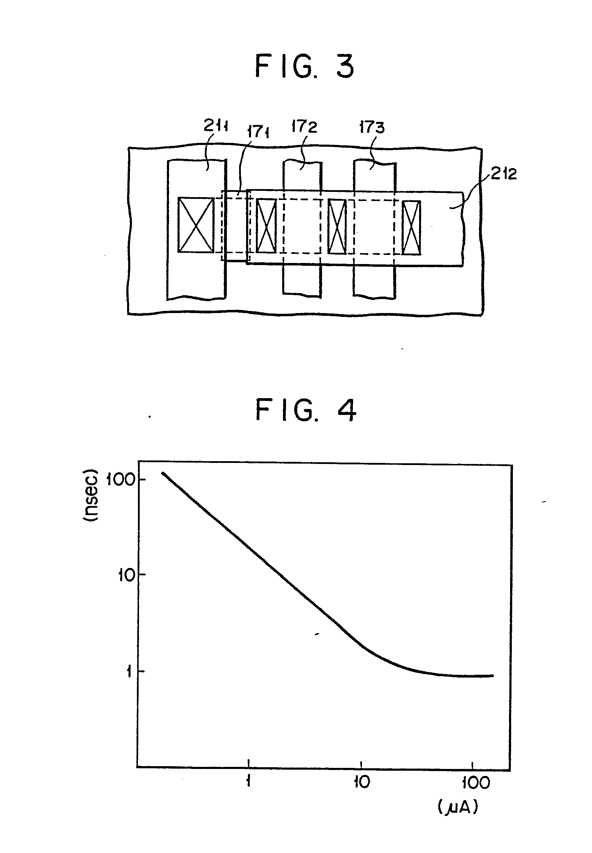

In the semiconductor device thus manufactured, the p-type region 16 serves as an internal base of a vertical transistor, i.e. a switching transistor, of the $I_2L$ gate. The $p^+$-type regions $20_3$ and $20_4$ serve as an external base of the switching transistor. As seen from Fig. 3 illustrating a plan view of the $I^2L$ gate in Fig. 1F, the base electrode $21_2$ crosses the polysilicon layers $17_2$ and $17_3$ to contact the external regions $20_2$, $20_3$ and $20_4$ on both sides of the collector regions $17_2$ and $17_3$.

As described above, since the emitter and collector of the injector transistor and the external collector of the switching transistor are formed with the mask of the polysilicon layers concurrently formed, the intervals between the adjacent polysilicon layers may be set to the minimum value determined by the mask dimension for patterning the polysilicon layers. Therefore, the lateral dimensions of the $I^2L$ gate can be reduced considerably and therefore an area of the base region of the switching transistor can also be reduced, resulting in further speeding up the operation speed of the device. A feature that the oxide layer 18 has the thick and thin portions 18a and 18b eliminates the need of the masking step in forming the contact holes for forming the $p^+$-type regions $20_1$ and $20_2$. That is, contact holes may be made by properly controlling the etching time to etch away the thin layer portions 18b. This contributes to the improvement of the packing density of the device.

A propagation delay time to power consumption of the $I^2L$ gate prepared by the above-mentioned manufacturing method was measured by using a ring oscillator. The result of the measurement is illustrated in Fig. 4. As seen from Fig. 4, the minimum value of the propagation delay time per gate is approximately 1 µs and remarkably improved compared to the conventional one.

In the above-mentioned embodiment, the $p^+$-type layers $20_1$ to $20_4$ are formed by an ion injection method. Those layers may also be formed in a manner that after the oxide layer etching, impurity is doped by an ordinary thermal diffusion method. Additionally, for forming the $p^+$-type layers $20_1$ to $20_4$, boron-doped polysilicon layers $21_1$ and $21_2$ may be used as a diffusion source. While, in the above-mentioned embodiment, the impurity diffusion step from the polysilicon layers $17_2$ and $17_3$ and the diffusion step of the $p^+$-type regions $20_1$ to $20_4$ are simultaneously performed, those steps may be performed separately one earlier than the other. Furthermore, the polysilicon layer $17_1$ not used as the diffusion source may be used for wiring.

**Claims**

1. A method for manufacturing a semiconductor device including a lateral injector transistor comprising the steps of:
forming at least one island region (13a) of a first conductivity type surrounded by a recessed insulation region (14) on a semiconductor substrate (12) of the first conductivity type;
forming partially a first insulating film (15) on the surface of said first conductivity type island region (13a), so that this first insulating film (15) covers that region of the island region (13a) at least in which it is intended to build the emitter region ($20_1$) and the base region of the lateral injector transistor;
forming partially a first region (16) of a second conductivity type in said island region (13a); and eliminating said first insulating film (15) except for that part that covers the later base region of the lateral injector transistor, characterized by forming impurity-doped polysilicon layers ($17_1$, $17_2$, $17_3$) of the first conductivity type on the surfaces of said first insulating film (15) and said first region (16), said polysilicon layers ($17_1$, $17_2$, $17_3$) crossing said first insulation film (15) and said second conductivity type first region (16);
covering the polysilicon layers ($17_1$, $17_2$, $17_3$) built on the first insulating film (15) and on the first region (16) by an insulating layer (18), doping impurity of the second conductivity type into said island region (13a) and said first region (16) with a mask of said polysilicon layers ($17_1$, $17_2$, $17_3$);
forming second regions ($19_1$, $19_2$) of the first conductivity type by diffusing the impurity doped in said polysilicon layers into said first region (16); and
connecting portions of said first region, which are not covered with said polysilicon layers, by a conductive layer ($21_2$).

2. A method according to claim 1, characterized in that said emitter region ($20_1$) and a collector region ($20_2$) of the lateral injector transistor and external base regions ($20_2$, $20_3$, $20_4$) of a switching transistor in the semiconductor device are formed in said island region (13a) and said internal base region (16), using said polysilicon layers ($17_1$, $17_2$, $17_3$) as the mask, and collector regions ($19_1$, $19_2$) of the switching transistor are formed by diffusing the impurity doped in said polysilicon layers into portions of said internal base region (16) right under said polysilicon layers and said external base regions are connected by a conductive layer ($21_2$).

3. A method for manufacturing a semiconductor device according to claim 2, characterized by further comprising a step to remove said first insulating film (15) with a mask of said polysilicon layers ($17_1$, $17_2$, $17_3$) after the step of forming said polysilicon layer and a step to enclose said polysilicon layers ($17_1$, $17_2$, $17_3$) with thick insulating films (18a), wherein impurity is doped into said island region (13a) and said internal base region (16) to form the emitter and collector regions ($20_1$, $20_2$) of said injector transistor and the external base regions ($20_2$, $20_3$, $20_4$) of said switching transistor with a mask of said polysilicon layers enclosed by said thick insulating films (18a).

4. A method for manufacturing a semiconductor device according to claim 3, characterized in that said impurity is doped by an ion implantation.

**Revendications**

1. Procédé de fabrication d'un dispositif semiconducteur comprenant un transistor latéral injecteur comprenant les étapes consistant à:

former au moins une région d'îlot (13a) d'un premier type de conductivité entourée d'une région d'isolation en creux (14) sur un substrat semiconducteur (12) du premier type de conductivité;

former partiellement une première couche isolante (15) sur la surface de la région d'îlot du premier type de conductivité (13a) de sorte que cette première couche isolante (15) recouvre au moins la partie de la région d'îlot (13a) dans laquelle on souhaite former la région d'émetteur ($20_1$) et la région de base du transistor injecteur latéral;

former partiellement une première région (16) d'un second type de conductivité dans la région d'îlot (13a); et

éliminer la première couche isolante (15) sauf pour la partie qui recouvre ladite région de base du transistor injecteur latéral,

caractérisé en ce qu'il comprend en outre les étapes consistant à:

former des couches de silicium polycristallin dopées par des impuretés ($17_1$, $17_2$, $17_3$) du premier type de conductivité sur les surfaces de la première couche isolante (15) et de la première région (16), ces couches de silicium polycristallin ($17_1$, $17_2$, $17_3$) s'étendant sur la première couche isolante (15) et la première région (16) du second type de conductivité;

revêtir les couches de silicium polycristallin ($17_1$, $17_2$, $17_3$) formées sur la première couche isolante (15) et sur la première région (16) au moyen d'une couche isolante (18),

introduire des impuretés dopantes du second type de conductivité dans la région d'îlot (13a) et la première région (16) au moyen d'un masque constitué desdites couches de silicium polycristallin ($17_1$, $17_2$, $17_3$);

former des secondes régions ($19_1$, $19_2$) du premier type de conductivité en faisant diffuser les impuretés dopantes des couches de silicium polycristallin dans ladite première région (16); et

connecter des parties de la première région, qui ne sont pas recouvertes desdites couches de silicium polycristallin, au moyen d'une couche conductrice ($21_2$).

2. Procédé selon la revendication 1, caractérisé en ce que ladite région d'émetteur ($20_1$) et une région de collecteur ($20_2$) du transistor injecteur latéral et les régions de base externe ($20_2$, $20_3$, $20_4$) d'un transistor de commutation dans le dispositif semiconducteur sont formées dans ladite région d'îlot (13a) et ladite région de base interne (16), en utilisant les couches de silicium polycristallin ($17_1$, $17_2$, $17_3$) comme masque, en ce que les régions de collecteur ($19_1$, $19_2$) du transistor de commutation sont formées en faisant diffuser les impuretées dopantes des couches de silicium polycristallin vers des parties de la région de base interne (16) juste en dessous des couches de silicium polycristallin, et en ce que lesdites régions de base externe sont connectées par une couche conductrice ($21_2$).

3. Procédé de fabrication d'un dispositif semiconducteur selon la revendication 2, caractérisé en ce qu'il comprend en outre une étape consistant à enlever la première couche isolante (15) au moyen du masque défini par lesdites couches de silicium polycristallin ($17_1$, $17_2$, $17_3$) après l'étape de formation desdites couches de silicium polycristallin et une étape consistant à enfermer lesdites couches de silicium polycristallin ($17_1$, $17_2$, $17_3$) dans des films isolants épais (18a), où une impureté est introduite dans ladite région d'îlot (13a) et ladite région de base interne (16) pour former les régions d'émetteur et de collecteur ($20_1$, $20_2$) du transistor injecteur et les règions de base externe ($20_2$, $20_3$, $20_4$) du transistor de commutation au moyen d'un masque constitué par les couches de silicium polycristallin enfermées dans les films isolants épais (18a).

4. Procédé de fabrication d'un dispositif semiconducteur selon la revendication 3, caractérisé en ce que ladite impureté est introduite par implantation ionique.

**Patentansprüche**

1. Verfahren zum Herstellen einer Halbleitervorrichtung mit mehreren Lasteralinjektionstransistoren, umfassend die folgenden Schritte:

Ausbilden mindestens einer von einer ausgesparten Isolationszone (14) umgebenen Inselzone (13a) eines ersten Leitfähigkeitstyps auf einem Halbleitersubstrat (12) des ersten Leitfähigkeitstyps,

teilweise Ausbilden einer ersten Isolierschicht (15) auf der Oberfläche der Inselzone (13a) des ersten Leitfähigkeitstyps, derart, daß diese erste Isolierschicht (15) mindestens den Bereich der Inselzone (13a) bedeckt, in welchem die Emitterzone ($20_1$) und die Basiszone des Lateralinjektionstransistors aufgebaut werden sollen,

teilweise Ausbilden einer ersten Zone (16) eines zweiten Leitfähigkeitstyps in der Inselzone (13a)

und Beseitigen der ersten Isolierschicht (15) mit Ausnahme des Teils, der die spätere Basiszone des Lateralinjektionstransistors bedeckt, dadurch gekennzeichnet, daß

Fremdatom-dotierte Polysiliziumschichten ($17_1$, $17_2$, $17_3$) des ersten Leitfähigkeitstyps auf den Oberflächen der ersten Isolierschicht (15) und der ersten Zone (16) ausgebildet werden, wobei die Polysiliziumschichten ($17_1$, $17_2$, $17_3$) die erste Isolierschicht (15) und die erste Zone (16) des zweiten Leitfähigkeitstyps überkreuzen,

die auf der Isolierschicht (15) und der ersten Zone (16) aufgebauten Polysiliziumschichten ($17_1$, $17_2$, $17_3$) mit einer Isolierschicht (18) bedeckt werden,

die Inselzone (13a) und die erste Zone (16) mittels einer Maske aus den Polysiliziumschichten ($17_1$, $17_2$, $17_3$) mit einem Fremdatom des zweiten Leitfähigkeitstyps dotiert werden,

zweite Zonen ($19_1$, $19_2$) des ersten Leitfähigkeitstyps durch Eindiffundieren des Fremdatoms, mit dem die Polysiliziumschichten ($17_1$, $17_2$, $17_3$) dotiert sind, in die erste Zone (16) erzeugt werden und

die nicht mit den Polysiliziumschichten bedeckten Abschnitte der ersten Zone durch eine Leiterschicht ($21_2$) (miteinander) verbunden werden.

2. Verfahren nach Anspruch 1, dadurch gekennzeichnet, daß

die Emitterzone ($20_1$) und eine Kollektorzone ($20_2$) des Lateralinjektionstransistors sowie externe Basiszonen ($20_2$, $20_3$, $20_4$) eines Schalttransistors in der Halbleitervorrichtung unter Heranziehung der Polysiliziumschichten ($17_1$, $17_2$, $17_3$) als Maske in der Inselzone (13a) in der internen Basiszone (16) ausgebildet werden und Kollektorzonen ($19_1$, $19_2$) des Schalttransistors durch Eindiffundieren des Fremdatoms, mit dem die Polysiliziumschichten dotiert sind, in die unmittelbar unter den Polysiliziumschichten befindlichen Abschnitte der internen Basiszone (16) ausgebildet werden und die externen Basiszonen durch eine Leiterschicht ($21_2$) (miteinander) verbunden werden.

3. Verfahren zum Herstellen einer Halbleitervorrichtung nach Anspruch 2,

weiterhin gekennzeichnet durch einen Schritt zum Entfernen der ersten Isolierschicht (15) mit einer Maske aus den Polysiliziumschichten ($17_1$, $17_2$, $17_3$) nach dem Schritt der Ausbildung der Polysiliziumschicht sowie einen Schritt zum Umhüllen der Polysiliziumschichten ($17_1$, $17_2$, $17_3$) mit dicken Isolierschichten (18a), wobei mittels einer Maske aus den von den dicken Isolierschichten (18a) umhüllten Polysiliziumschichten die Inselzone (13a) und die interne Basiszone (16) mit einem Fremdatom dotiert werden, um die Emitter- und Kollektorzonen ($20_1$, $20_2$) des Injektionstransistors und die externen Basiszonen ($20_2$, $20_3$, $20_4$) des Schalttransistors auszubilden.

4. Verfahren zum Herstellen einer Halbleitervorrichtung nach Anspruch 3, dadurch gekennzeichnet, daß die Dotierung mit dem Fremdatom durch Ionenimplantation erfolgt.

FIG. 1A

FIG. 1B

FIG. 1C

FIG. 1D

# FIG. 1E

# FIG. 1F

# FIG. 2

# FIG. 3

# FIG. 4